# EUROPEAN PATENT SPECIFICATION

(11) **EP 0 776 031 B1**
(45) Date of publication and mention of the grant of the patent: **26.02.2003**
(21) Application number: 96308435.5
(22) Date of filing: 21.11.1996
(51) Int. Cl.: H01L 21/3065, B26F 3/00

(54) **A method for processing a semiconductor crystal ingot**
Verfahren zur Bearbeitung eines Halbleiterkristallblocks
Méthode pour le traitement d'un lingot semi-conducteur

(30) Priority: 21.11.1995 JP 30274995; 21.11.1995 JP 30275095
(43) Date of publication of application: 28.05.1997
(73) Proprietor: Air Water Inc., Sapporo-shi, Hokkaido 060-0003 (JP)
(72) Inventor: Yoshino, Akira, Chikko Shinmachi, Sakai-shi, Osaka 592 (JP); Yokoyama, Takashi, Chikko Shinmachi, Sakai-shi, Osaka 592 (JP); Ohmori, Yoshinori, Chikko Shinmachi, Sakai-shi, Osaka 592 (JP); Yamamoto, Kazuma, Chikko Shinmachi, Sakai-shi, Osaka 592 (JP)
(74) Representative: Marlow, Nicholas Simon

(56) References cited:
- EP-A- 0 259 572
- US-A- 4 465 550
- US-A- 4 624 736
- US-A- 4 693 779
- US-A- 5 110 407
- US-A- 5 419 798

## Description

The present invention relates to a method for processing a semiconductor crystalline ingot.

A wafer employed for various kinds of semiconductor devices can be obtained by cutting a crystalline ingot such as Si or GaAs at specific intervals so as to form plates and mirror polishing the surface of the plates; a diamond blade saw or a wire saw for metal cutting is employed to cut the ingot. That is, the ingot is cut by pressing thereon a diamond blade rotating at a high speed or a wire saw vibrating at a high speed.

The thus obtained wafer surface is processed in minute detail, for example by recessing process, so that semiconductor devices such as large scale integrated circuits (LSI) can be formed. Such minute processes include a method wherein the wafer surface is melted by a carbon dioxide gas laser, a YAG laser or the like, and evaporated so as to be recessed and a method wherein resist is applied to a wafer surface and etching is conducted after exposure so that a recess can be formed.

However, there is a problem with the cost effectiveness of such methods applied to a crystalline ingot because the neighbourhood of the cut is deformed or destroyed so that a significant extra thickness of the ingot is wasted. More specifically, about 500 µm thickness is wasted when cutting a wafer, which means about 50% of an ingot may be wasted when cutting wafers of 500 µm thickness. In addition, as a cutting tool is repeatedly used for cutting, the edge may be nicked and the sharpness may deteriorate, so that a diamond blade, a wire or the like requires time-consuming periodical replacement. Further, there is another problem in that smears of cutting fluid introduced into portions to be cut for cooling and lubrication, and debris generated by cutting may scatter and lead to a deterioration in the work environment. Still further, the cutting fluid including the debris is difficult to recycle or dispose of because separation of the debris and the cutting fluid must be achieved.

Also, in a method wherein a laser or the like is employed for minutely processing a wafer, there are problems in that processing accuracy is not good because the wafer surface is melted so that molten liquid may expand or flow, and that the part of the wafer which is melted and evaporated may adhere to another part of the wafer surface, cool and harden, resulting in a deterioration in surface smoothness.

EP-A-0 259 572 discloses the laser etching of semiconductor materials, US-A-5 419 798 discloses laser cutting of a diamond film.

A method wherein etching is conducted after application of resist is shown in Figs. 9 to 14. A resist, for example, photoresist (photosensitive organic high polymer), 52 is applied to the surface of a wafer 51 as shown in Figs. 9 and 10, and a photo mask 53 in which a predetermined circuit pattern R is printed is attached thereto and exposed light (Fig. 11). After being developed, unexposed parts (dissolved into the developing solution) of the resist 52 flow away as shown in Fig. 12 so that a pattern is formed on the surface of the wafer 51. Subsequently, a recess 54 can be formed (shown in Fig. 13) by plasma dry etching or the like using the resist 52 as a mask. The resist 52 is peeled off and the wafer surface cleaned, resulting in a wafer 51 (shown in Fig. 14) in which a recess 54 as a circuit pattern is formed. This is a complicated process and leads to low productivity. Furthermore, all the resist 52 applied on the whole surface of the wafer 51 is eventually removed, which brings about high cost in materials and disposal or recycling of the liquid.

Accordingly, it has been desired to provide a superior method for processing a semiconductor material, for example, cutting a crystalline ingot, minute processing on a wafer surface and the like, hygienically, easily and precisely, and an apparatus employed therefor.

To accomplish the above object, a method as outlined in the claims is provided.

The invention will now be described in detail. Various kinds of crystalline ingot of semiconductor materials are employed as a wafer material, for example, a monocrystal or a polycrystal of Si, GaAs, SiO₂, Si₃N₄, Al₂O₃, or the like. The shapes of the crystalline ingot and the wafer are not limited specifically.

As an etching gas for processing the semiconductor material, those gases which have the physical property of reacting with a component of the semiconductor material so as to produce volatile matter are preferred, for example, NF₃, CCl₂F₂, CF4, C₂F₆, C₃F₈, CHF₃, CCl₄, SF₆, CCl₃F, CIF₃, HCl and the like. These gases are employed alone or in combination of two or more.

To excite the gas component of the etching gas, laser radiation or light quantum irradiation is conducted. In laser radiation, a laser beam with a wavelength within the range 0.1 to 10 µm is preferable, for example, YAG, Ar and the like. The output thereof is usually set up within a range of 1 to 100 W. Meanwhile, in light quantum irradiation, it is preferable to employ Hg, Xe or the like usually within a range of 0.1 to 10 kW as a light source. The semiconductor material surface is heated up to from 300 to 600°C by such irradiation; heating to less than 300°C does not impart sufficient exciting effect to the etching gas, resulting in a dull reaction. On the other hand, heating to over 600°C may cause thermal quality change of the processed semiconductor materials.

Further, it is preferable for such irradiation to be passed through light gathering means such as a convex lens so that the laser irradiation or light quantum irradiation does not diffuse onto the semiconductor material surface but is concentrated on the predetermined limited narrow part. It is necessary to set up a spot diameter of the semiconductor material to be heated up to not less than 300°C by laser irradiation or light quantum irradiation within the range of about 1 to 100 µm.

The invention will be more fully described and will be better understood from the following description, taken with the appended drawings, in which:

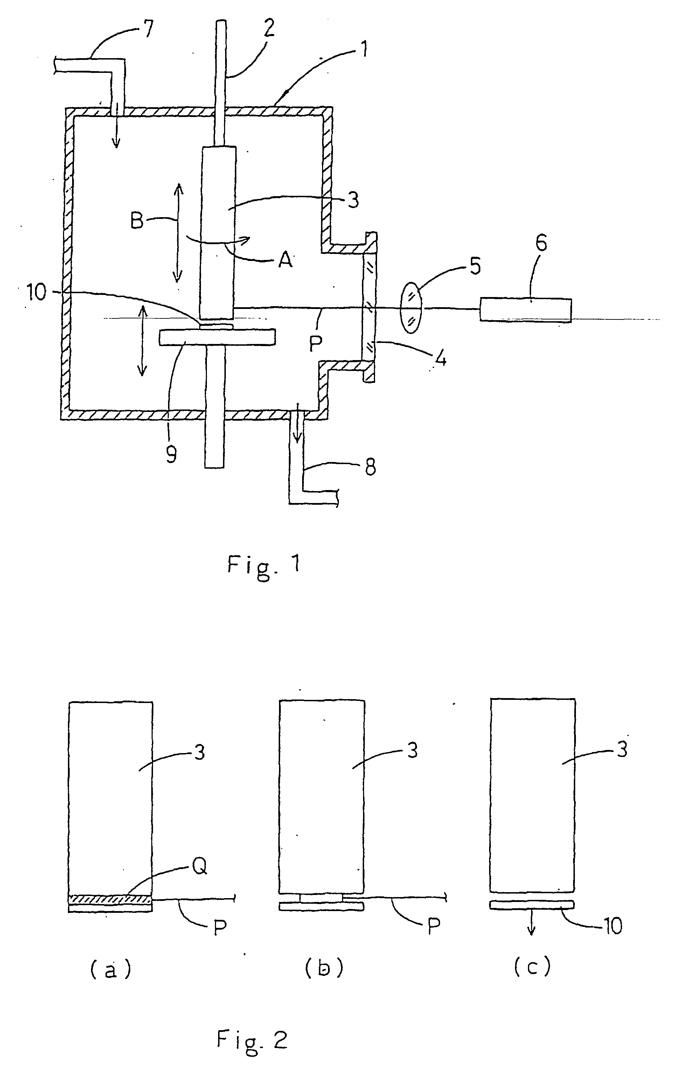

Fig. 1 is a schematic view of an etching apparatus;
Fig. 2(a) shows diagrammatically the first step of cutting a wafer with the apparatus of Fig. 1, (b) shows the second step thereof and (c) shows the third step thereof;

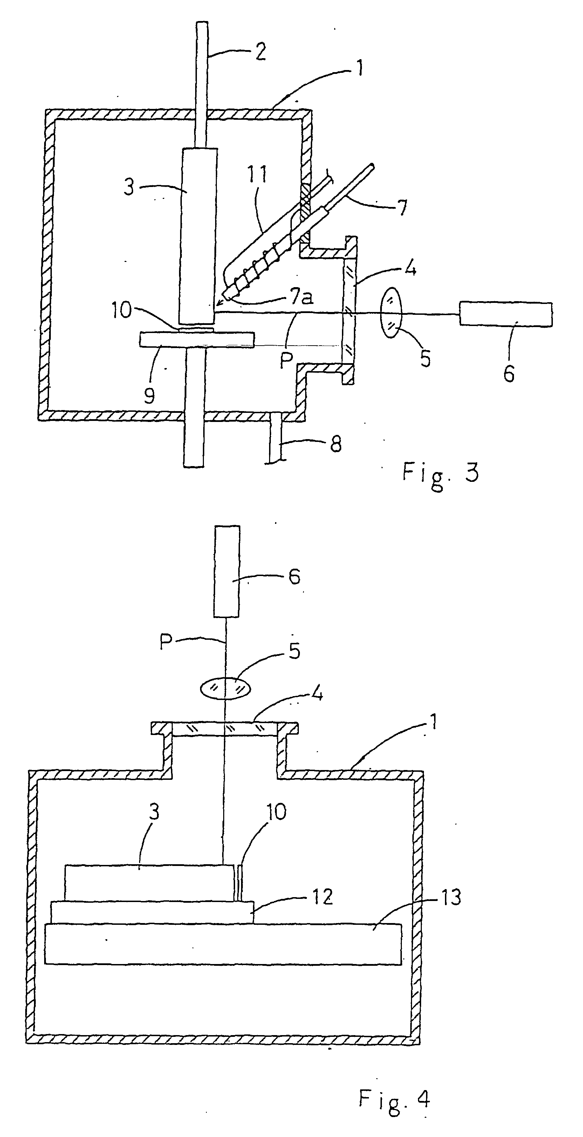

Fig. 3 is a schematic view of an apparatus of another example;
Fig. 4 is a schematic view of an apparatus of another example;

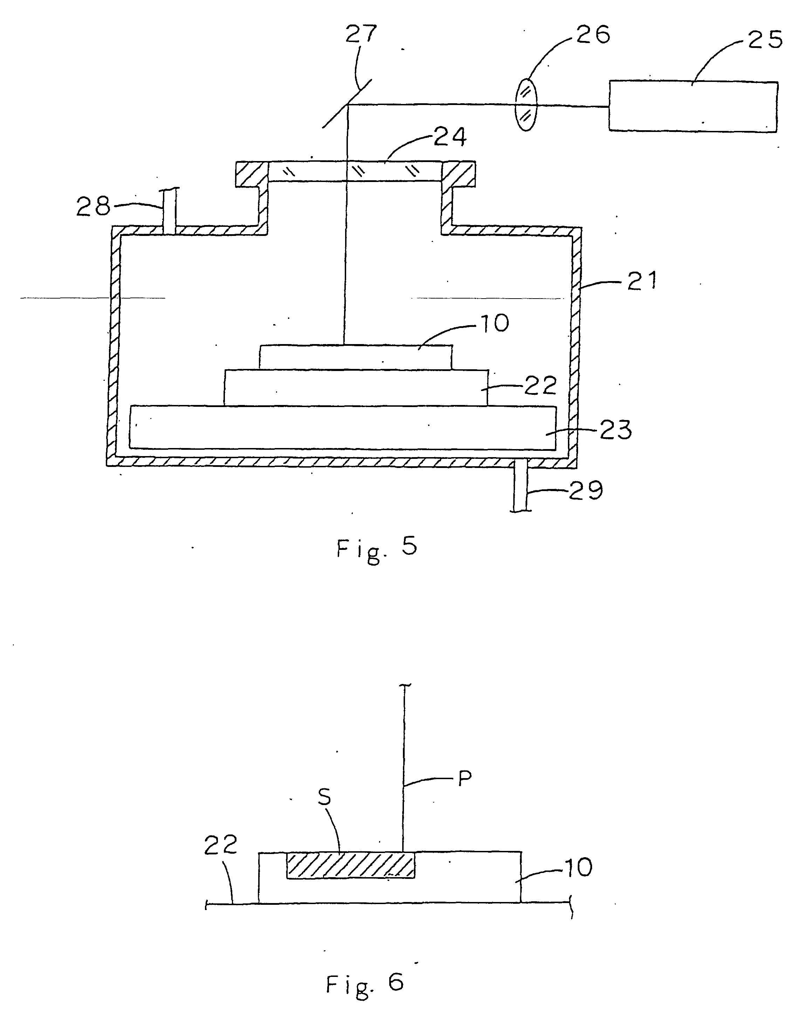

Fig. 5 is a schematic view of an apparatus of another example;
Fig. 6 is an operational view of recessing by an apparatus;

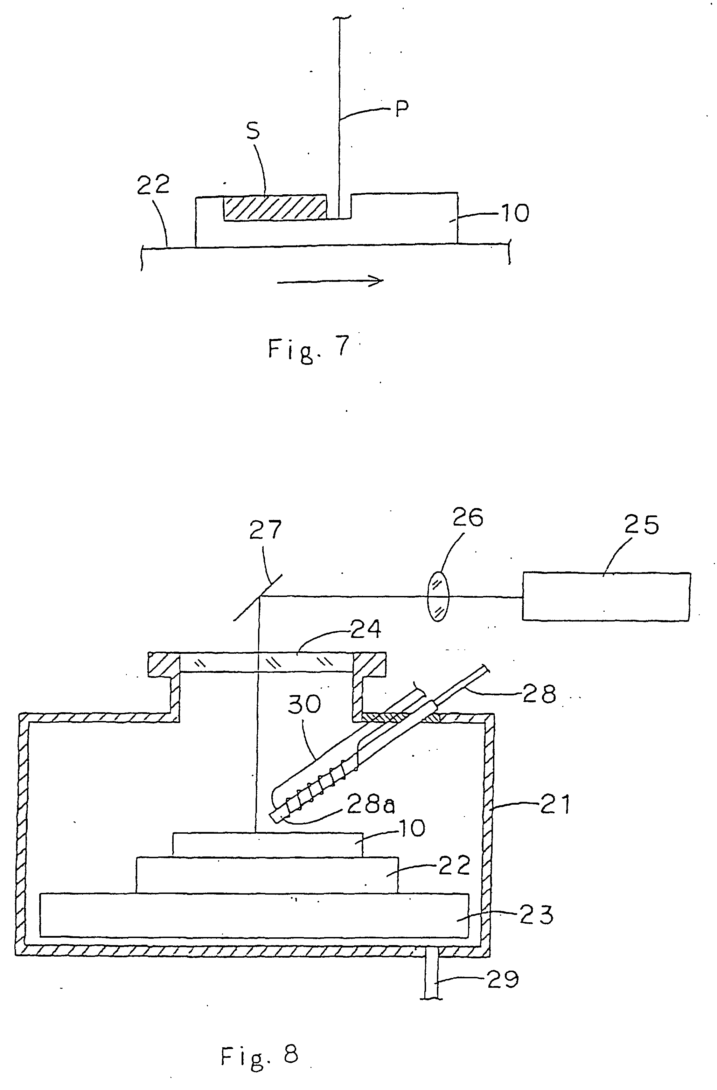

Fig. 7 is another operational view of recessing by the above apparatus;
Fig. 8 is a schematic view of an apparatus of another example; and

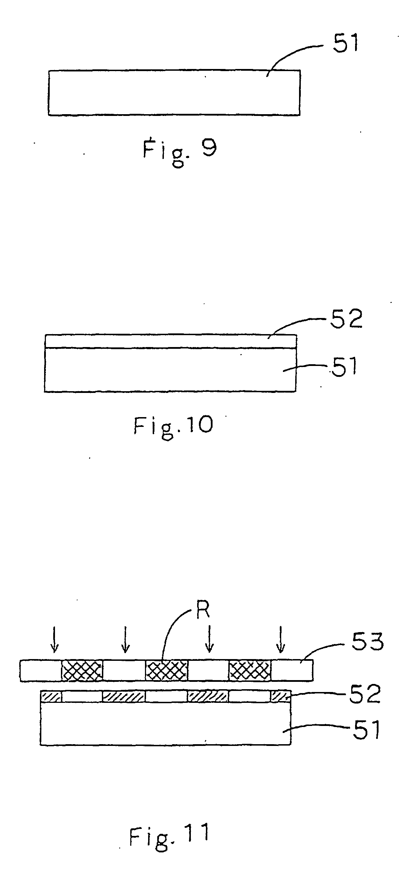

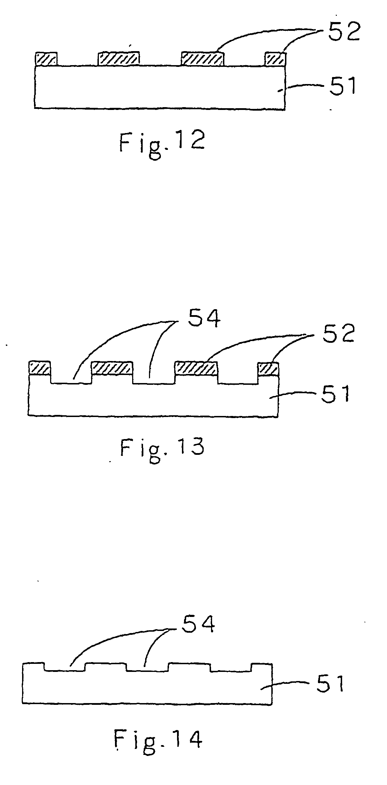

Figs. 9 to 14 show diagrammatically a general method of recessing a wafer surface.

Fig. 1 illustrates one embodiment of an apparatus used in a method for obtaining a wafer by applying laser irradiation to a cylindrical crystalline ingot. In this apparatus, a shaft 2 suspended from above is installed in the centre of a closed chamber 1. A cylindrical crystalline ingot (just referred to as an ingot hereinafter) 3 is to be attached to the lower end of the shaft 2 coaxially. Rotation or up-down movement can be imparted to the shaft 2 from outside the chamber 1, whereby the ingot 3 may be driven circumferentially as shown by the arrow A or perpendicularly as shown by the other arrow B.

A transparent window 4 of quartz glass is in the side wall of the chamber 1. A laser transmitter 6 is aligned by a convex lens 5 for gathering light onto the face of the transparent window 4 so that laser irradiation may be conducted on the surface of the ingot 3.

A supply tube 7 through which an etching gas is introduced for cutting the ingot 3 into the chamber 1 is connected to the ceiling of the chamber 1 while a withdrawal tube 8 for withdrawing an exhaust gas is connected to the bottom of the chamber 1.

A wafer holding stage 9 holds wafers 10 cut from the ingot 3 and can descend in increments of the thickness of a wafer. When a specific number of wafers 10 has accumulated, wafer withdrawal means (not shown) connected with a lower side of the chamber 1 operate so that the wafers 10 on the stage 9 are removed from the chamber. When the wafers 10 are removed and the stage 9 becomes vacant the stage 9 ascends up to an initial height so as to accumulate further wafers 10 from the ingot 3.

By employing the above apparatus, wafers 10 can be cut as follows. First, a cylindrical ingot 3 of Si monocrystal is attached to the shaft 2 and mounted in the chamber 1. Consecutively, a vacuum is drawn through the exhaust gas withdrawal tube 8 so that the chamber 1 is evacuated to the order of 10⁻³ torr. Then, NF₃ gas is introduced therein through the etching gas supply tube 7.

Successively, the laser transmitter 6 is actuated so that a laser beam P is focused on one predetermined spot (the shadowed portion Q) of the surface of the ingot 3 as shown in Fig. 2(a). At that time, light gathering condition is arranged in such a manner that the spot diameter of a photo recipient of the surface of the ingot 3 is within 100 µm and the temperature on the spot of the ingot 3 is within the range 300 to 600°C. In this state, NF₃ is excited on the surface neighbourhood of the ingot 3 and the Si component of the ingot 3 and NF₃ gas react as follows so that the ingot 3 is etched. ${\text{4NF}}_{\text{3}} {\text{+3Si → 3SiF}}_{\text{4}} {\text{(volatile matter) + 2N}}_{\text{2}} \text{(gas)}$

The ingot 3 is slowly rotated by the shaft 2, the part where the laser beam P is applied moves circumferentially step by step, as shown in Fig. 2(b), so as to create a recess. Finally, as shown in Fig. 2(c), the wafer 10 is cut off by etching the predetermined portion right through. The cut wafer 10 drops onto the stage 9 (as shown in Fig. 1).

Next, laser irradiation is interrupted and the shaft 2 is lowered by the thickness of the wafer 10 (for example, 500 µm) and an extra space (for example, 100 µm) so that the ingot 3 is positioned in such a manner that the next predetermined part receives the laser beam. Then, laser irradiation is resumed so that the next wafer 10 is cut in the same way. By repeating this process, wafers 10 can be obtained at specific intervals consecutively. The wafers 10 piled on the stage 9 are taken away from the chamber 1 periodically by the wafer withdrawal means as mentioned above.

Since the laser beam superior in parallelism can be gathered and the spot diameter can be focused (for example, to not more than 100 µm) according to the above apparatus, the etching gas (NF₃) can be excited within the range so as to evaporate and remove the surface of the ingot 3 whereby the extra material removed can be greatly decreased compared with prior art methods, resulting in minimizing waste in cutting. Further, the work environment is clean and hygienic because cutting fluid or debris is not scattered, in contrast to prior art methods. Furthermore, the present invention achieves good workability without tool replacement.

Fig. 3 illustrates another embodiment. In the example of Fig. 1 excitement of the etching gas is achieved by laser irradiation only, while in this embodiment the etching gas itself introduced into the chamber 1 is heated so that excitement can be conducted within a shorter time. In this apparatus, a lower-flow end 7a of the etching gas supply tube 7 extends near where the laser beam P impinges on the ingot 3, and a heater coil 11 is wound on the periphery of the lower-flow end 7a. The etching gas passing therethrough is heated by the heater coil 11 to a high temperature and is sprayed on the surface of the ingot 3 in such a state. The same effects can be achieved in this method as in the embodiment of Fig. 1. Further, excitement of the etching gas can be achieved in a shorter time, resulting in a shorter processing time compared with the embodiment of Fig. 1. In addition, it is preferable to heat the etching gas to about 300 to 600°C, the same as in heating with a laser beam. The means for heating the etching gas is not limited to the coil 11 shown in Fig. 3.

Fig. 4 shows another example. In the embodiments of Figs. 1 and 3 the ingot 3 is cylindrical, is installed on the shaft 2 and rotated, or lowered or raised so that every small area of the predetermined part to be cut is moved gradually. On the other hand, this apparatus is suitable for processing a prismatic ingot 3. The ingot 3 is put on an X-Y stage 12, irradiated by a laser beam P, as shown in the figure, and moved across the X-Y stage 12 horizontally or perpendicularly. A base 13 supports the X-Y stage 12. The same effects can be achieved in using this apparatus as by the embodiment of Fig. 1.

Fig. 5 illustrates one example of an apparatus for conducting minute processing on a monocrystal silicon wafer surface by laser irradiation according to the present invention. This apparatus includes an X-Y stage 22, movable arbitrarily in a X-Y directions, with a wafer 10 thereon, in the chamber 21 and a base 23 supporting the stage.

Further, a transparent window 24 of quartz glass is in the ceiling of the chamber 21. Laser irradiation from a laser transmitter 25 aligned outside the chamber 21 passes through the window 24 through a convex lens 26 for gathering light and a reflecting mirror 27 for refracting the passage of the laser beam through a right angle, and finally reaches the surface of the wafer 10. An etching gas supply tube 28 and an exhaust gas withdrawal tube 29 are provided to the chamber 21.

The wafer 10 is mounted on the X-Y stage 22 and withdrawn automatically after being processed minutely, by means for loading and withdrawing wafers (not shown) connected to a side wall of the chamber 21.

By employing the apparatus, minute processing (recessing) can be conducted on the surface of the wafer 10 as follows. First, a wafer of Si monocrystal is put on the X-Y stage 22. Next, a vacuum is drawn through the exhaust gas withdrawal tube 29 as that the chamber 21 is evacuated to the order of 10⁻³ torr. Then, NF₃ gas is introduced therein through the etching gas supply tube 28.

Successively, the laser transmitter 25 is actuated as shown in Fig. 6, the laser beam P is focused upon one predetermined spot to be recessed (shadowed portion S) of the surface of the wafer 10. At that time, light gathering condition is arranged in such a manner that the spot diameter of photo recipient is within 100 µm and the surface temperature on the spot of the wafer 10 is within the range 300 to 600°C. In this state, NF₃ is excited on the surface neighbourhood of the wafer 10, as shown in Fig. 7, so that the photo recipient of the surface of the wafer 10 can be etched in the same way as in the embodiment of Fig. 1.

As the wafer 10 is moved slowly by the X-Y stage 22 right to left as shown by the arrow, the part to be irradiated by the laser beam P moves gradually so as to be recessed. Finally, all the predetermined part S is etched, whereby an aiming minute processing can be conducted. The wafer 10 after being processed is withdrawn from the chamber 21.

Since the laser beam superior in parallelism can be gathered and the spot diameter can be focused on (for example, within a range of about 1 to 100 µm) according to the above method, an etching gas (NF₃) can be excited within the range so as to evaporate and remove the very spot on the surface of the wafer 10. This means that only if a suitable spot diameter is established in accordance with the recess width and the moving speed of the X-Y stage 22 is appropriately adjusted, recessing in the desired shape can be conducted precisely. Further, since the surface of the wafer 10 is not melted to be evaporated but a component of the wafer 10 is removed as volatile matter by chemical reaction, there is no risk of re-adhesion, unlike when a wafer surface is melted and evaporated. Furthermore, since this method does not require the multiple processes necessary for a dry etching method with a masking of resist, product efficiency is excellent and cost reduction can be achieved without the extra cost of materials and processing necessary for resist, photomask and the like. Still further, the surface of the wafer 10 is heated to 300 to 600°C by the laser beam P, which will not cause any problem in device production or thermally damage the wafer 10.

Fig. 8 illustrates another example. In this apparatus, a lower-flow end 28a of an etching gas supply tube 28 extends near to where the laser beam P impinges on the ingot 3, a heater coil 30 is wound around the lower-flow end 28a. The etching gas passing therethrough is heated by the heater coil 30 to a high temperature, and sprayed on a surface of the wafer 10 in such a state. The same effects can be realised in this method as by the embodiment of Fig. 5. Further, excitement of the etching gas can be conducted in a shorter time, resulting in a shorter processing time compared with the embodiment of Fig. 5. In addition, it is preferable to set up a heating temperature of the etching gas at about 300 to 600°C, the same as in heating with the laser beam. However, the means for heating the etching gas is not limited to the coil 30 shown in Fig. 8.

In these embodiments, the laser transmitters 6 and 25 may be replaced by a light emitting apparatus such as a Hg lamp and excitement of the etching gas may be conducted by light quantum irradiation.

In case the material is to be processed with a repetitive pattern, plural laser transmitters such as 6 or 25 may be provided for one chamber such as 1 or 21 at different positions so that plural laser beams can be applied to an ingot 3 or wafer 10 for simultaneously conducting processing on the same patterns, resulting in improvement in workability.

As mentioned above, the present invention relates to a method wherein the etching gas is excised with laser irradiation so that component of the etching gas and a component of the semiconductor material chemically react whereby a predetemined part on the surface of the semiconductor material is volatilized and removed. Therefore, according to a method of the present invention, laser irradiation or light quantum irradiation can be focused on a small area (a spot diameter: about 1 to 100 µm), within which the surface of the material can be volatilized and removed, whereby a desired shape can be obtained with high precision. When a wafer is cut from a crystalline ingot by the above method, the extra material removed can be greatly decreased compared with prior art methods, minimizing waste in cutting. Further, the work environment is clean and hygienic because cutting fluid or debris is not scattered, which is different from prior art methods. Furthermore, the present invention achieves good workability without tool replacement. Still further, since a component of the wafer is removed as volatile matter by chemical reaction in this method of processing a minute recess on the wafer surface, in contrast to a method which the wafer surface is melted and evaporated, there is no risk of re-adhesion. Furthermore, since the present invention does not require the multiple processes necessary for a etching method with a masking of resist, product efficiency is excellent and cost reduction can be achieved without the extra cost of materials and processing necessary for resist, photomask and the like.

## Claims

1. A method of processing a semiconductor crystalline ingot, comprising:
supplying the etching gas to a predetermined part of the crystalline ingot to be cut;
exciting a gas component of the etching gas by laser radiation thereby to heat a spot region with a diameter of 1 to 100µm to from 300 to 600°C; and
chemically reacting a constituent of the crystalline ingot and the excited gas component so as to be volatile and remove the said constituent at every small area of the predetermined part and repeating this successively as the position of the small area is moved, and finally removing the predetermined part by volatilization as a whole so that a wafer can be cut.

2. A method according to claim 1 wherein adjacent small areas of the surface of the crystalline ingot are volatilized and removed consecutively until a wafer is detached from the ingot.

3. A method according to claim 1 or 2 wherein the etching gas comprises at least one of NF₃, CCl₂F₂, CF₄, C₂F₆, C₃F₈, CHF₃, CCl₄, SF₆, CCl₃F, ClF₃ and HCl.

4. A method according to any of claims 1 to 3, wherein the etching gas is heated to from 300 to 600°C when being supplied and sprayed on the said predetermined part of the said surface.

## Patentansprüche

1. Verfahren zum Bearbeiten eines rohen Halbleiterkristalls, umfassend:
Zuführen des Ätzgases zu einem vorbestimmten Teil des zu schneidenden Kristallrohlings,
Erregen einer Gaskomponente des Ätzgases durch Laserstrahlung, um dadurch einen Punktbereich mit einem Durchmesser von 1 bis 100 um auf 300 bis 600°C zu erwärmen, und
Herbeiführen einer chemischen Reaktion des Kristallrohlings und der erregten Gaskomponente, sodass sie flüchtig sind und den genannten Bestandteil an jedem kleinen Bereich des vorbestimmten Teils entfernen, und aufeinanderfolgendes Wiederholen dessen, während die Position des kleinen Bereichs verschoben wird, und schließlich Entfernen des vorbestimmten Teils durch Verdampfung als Ganzes, damit ein Wafer abgetrennt werden kann.

2. Verfahren nach Anspruch 1, bei dem aneinander grenzende kleine Bereiche der Oberfläche des Kristallrohlings fortlaufend verdampft und entfernt werden, bis ein Wafer vom Rohling abgetrennt worden ist.

3. Verfahren nach Anspruch 1 oder 2, bei dem das Ätzgas wenigstens eines der Folgenden umfasst: NF₃, CCl₂F₂, CF₄, C₂F₆, C₃F₈, CHF₃, CCl₄, SF₆, CCl₃F, ClF₃ und HCl.

4. Verfahren nach einem der Ansprüche 1 bis 3, bei dem das Ätzgas, während es zugeführt wird, auf 300 bis 600°C erwärmt wird, und auf den genannten vorbestimmten Teil der genannten Oberfläche gesprüht wird.

## Revendications

1. Procédé de traitement d'un lingot semi-conducteur cristallin, comprenant :
la fourniture du gaz de gravure à une partie prédéterminée du lingot cristallin à découper ;
l'excitation d'un composant de gaz du gaz de gravure par rayonnement laser pour ainsi chauffer une région ponctuelle d'un diamètre de 1 à 100 µm de 300 à 600°C ; et
la réaction chimique d'un constituant du lingot cristallin et du composant de gaz excité de manièra à rendre volatile et à supprimer ledit constituant au niveau de chaque petite zone de ladite partie prédéterminée et la répétition, de ceci successivement au fur et à mesure que la position de la petite zone est déplacée, et enfin l'élimination de la partie prédéterminée par évaporation complète de manière à pouvoir découper une tranche.

2. Procédé selon la revendication 1, dans lequel de petites zones adjacentes de la surface du lingot cristallin sont évaporées et éliminées consécutivement jusqu'à ce qu'une tranche se détache du lingot.

3. Procédé selon la revendication 1 ou 2, dans lequel le gaz de gravure comprend au moins l'un de NF₃, CCl₂F₂, CF₄, C₂F₆, C₃F₈, CHF₃, CCl₄, SF₆, CCl₃F, ClF₃ et Hcl.

4. Procédé selon l'une quelconque des revendications 1 à 3, dans lequel le gaz de gravure est chauffé de 300 à 600°C lorsqu'il est fourni et vaporisé sur ladite partie prédéterminée de ladite surface.
